# EUROPÄISCHE PATENTSCHRIFT

(11) **EP 2 483 198 B1**
(45) Veröffentlichungstag und Bekanntmachung des Hinweises auf die Patenterteilung: **02.11.2016**
(21) Anmeldenummer: 10760290.6
(22) Anmeldetag: 20.09.2010
(51) Int. Cl.: B81C 99/00

(54) **DREIDIMENSIONALE MIKRO-STRUKTUR, ANORDNUNG MIT MINDESTENS ZWEI DREIDIMENSIONALEN MIKRO-STRUKTUREN, VERFAHREN ZUM HERSTELLEN DER MIKRO-STRUKTUR UND VERWENDUNG DER MIKRO-STRUKTUR**
THREE-DIMENSIONAL MICRO-STRUCTURE, ARRANGEMENT WITH AT LEAST TWO THREE-DIMENSIONAL MICRO-STRUCTURES, METHOD FOR PRODUCING THE MICRO-STRUCTURE AND USE OF THE MICRO-STRUCTURE
MICROSTRUCTURE TRIDIMENSIONNELLE, ENSEMBLE DOTÉ D'AU MOINS DEUX MICROSTRUCTURES TRIDIMENSIONNELLES, PROCÉDÉ DE PRODUCTION DE LA MICROSTRUCTURE ET UTILISATION DE LA MICROSTRUCTURE

(30) Priorität: 29.09.2009 DE 102009043414
(43) Veröffentlichungstag der Anmeldung: 08.08.2012
(73) Patentinhaber: Siemens Aktiengesellschaft, 80333 München (DE)
(72) Erfinder: HEDLER, Harry, 82110 Germering (DE); ZAPF, Jörg, 81927 München (DE)
(86) Internationale Anmeldenummer: PCT/EP2010/063811
(87) Internationale Veröffentlichungsnummer: WO 2011/039070

(56) Entgegenhaltungen:
- FR-A1- 2 902 237
- US-A1- 2007 059 584
- US-A1- 2008 099 925
- US-B1- 6 551 849
- WANG L ET AL: "High aspect ratio through-wafer interconnections for 3D-microsystems", PROCEEDINGS OF THE IEEE 16TH. ANNUAL INTERNATIONAL CONFERENCE ON MICRO ELECTRO MECHANICAL SYSTEMS. MEMS 2003. KYOTO, JAPAN, Bd. 16, 19. Januar 2003 (2003-01-19), Seiten 634-637, XP010637052, IEEE, US DOI: DOI:10.1109/MEMSYS.2003.1189829 ISBN: 978-0-7803-7744-8
- LETANT S E ET AL: "Nanochannel arrays on silicon platforms by electrochemistry", NANO LETTERS, ACS, WASHINGTON, DC, US, Bd. 4, Nr. 9, 1. September 2004 (2004-09-01), Seiten 1705-1707, XP007917762, ISSN: 1530-6984, DOI: DOI:10.1021/NL049111C [gefunden am 2004-07-31]

## Beschreibung

Die Erfindung betrifft ein Verfahren zum Herstellen einer Mikro-Struktur.

Für verschiedene Anwendungen ist eine Struktur mit sehr großer Oberfläche von Vorteil. Eine derartige Struktur ist beispielsweise eine poröse Struktur. Eine Eigenschaft einer solchen Struktur, beispielsweise eine Material-Zusammensetzung der Struktur, kann nur begrenzt variiert werden.

US 2008/099925 A1 lehrt ein Verfahren zum Herstellen einer dreidimensionalen Mikro-Struktur, die eine Vielzahl von nebeneinander, bezüglich ihrer jeweiligen Mikro-Säulen-Längsausdehnung im Wesentlichen parallel zueinander und voneinander beabstandet angeordnete Mikro-Säulen mit mindestens einem nicht-einkristallinen Mikro-Säulen-Material, die jeweils einen Mikro-Säulen-Durchmesser aus dem Bereich von 0,1 µm bis 200 µm aufweisen, und einen zwischen benachbarten Mikro-Säulen angeordneten Mikro-Säulen-Zwischenraum mit einem zwischen den benachbarten Mikro-Säulen aus dem Bereich von 1 µm bis 100 µm ausgewählten Mikro-Säulen-Abstand aufweist, mit folgenden Verfahrensschritten: a) Bereitstellen einer Schablone mit Schablonen-Material, wobei die Schablone eine im Wesentlichen zur Mikro-Struktur inverse, drei dimensionale Schablonen-Struktur mit säulenartigen Schablonen-Hohlräumen aufweist, b) Anordnen von einem ersten Mikro-Säulen-Material in den säulenartigen Hohlräumen, so dass die Mikro-Säulen entstehen, und c) zumindest teilweises Entfernen des Schablonen-Materials.

Aufgabe der Erfindung ist es, eine Struktur mit sehr großer Oberfläche bereitzustellen, deren Eigenschaften in einem weiten Bereich geändert werden können.

Zur Lösung der Aufgabe wird ein Verfahren zum Herstellen einer dreidimensionale Mikro-Struktur angegeben, die eine Vielzahl von nebeneinander, bezüglich ihrer jeweiligen Mikro-Säulen-Längsausdehnung im Wesentlichen parallel zueinander und voneinander beabstandet angeordnete Mikro-Säulen mit mindestens einem amorphen, nicht-einkristallinen Mikro-Säulen-Material, die jeweils einen Mikro-Säulen-Durchmesser aus dem Bereich von 0,1 µm bis 200 µm aufweisen, und einen zwischen benachbarten Mikro-Säulen angeordneten Mikro-Säulen-Zwischenraum mit einem zwischen den benachbarten Mikro-Säulen aus dem Bereich von 1 µm bis 100 µm ausgewählten Mikro-Säulen-Abstand aufweist, wobei zumindest eine der Mikro-Säulen mindestens zwei entlang der Mikro-Säulen-Längsausdehnung angeordnete Abschnitte mit voneinander unterschiedlichen amorphen, nicht-einkristallinen Mikro-Säulen-Materialien aufweist. Dabei weist das Verfahren die folgenden Verfahrensschritten auf: a) Bereitstellen einer Schablone mit Schablonen-Material, wobei die Schablone eine im Wesentlichen zur Mikro-Struktur inverse, drei dimensionale Schablonen-Struktur mit säulenartigen Schablonen-Hohlräumen aufweist, b) Anordnen von einem ersten Mikro-Säulen-Material und einem von dem ersten Mikro-Säulen-Material unterschiedlichen zweiten Mikro-Säulen-Material in den säulenartigen Schablonen-Hohlräumen, so dass die Mikro-Säulen entstehen, und zumindest eine der Mikro-Säulen mindestens zwei entlang der Mikro-Säulen-Längsausdehnung angeordnete Abschnitte mit voneinander unterschiedlichen amorphen, nicht-einkristallinen Mikro-Säulen-Materialien aufweist, und c) zumindest teilweises Entfernen des Schablonen-Materials. Dabei ist der Mikro-Säulen-Durchmesser insbesondere aus dem Bereich von 0,3 µm bis 200 µm ausgewählt. Eine im Wesentlichen parallele Anordnung der Mikro-Säulen bedeutet dabei, dass es hinsichtlich der (gemittelten) Ausrichtung der Mikro-Säulen-Längsausdehnungen Abweichungen von bis zu 10° geben kann.

Vorzugsweise ist die Mikro-Säulen-Längsausdehnung zumindest einer der Mikro-Säulen aus dem Bereich von 50 µm bis 10 mm und insbesondere aus dem Bereich von 100 µm bis 1 mm ausgewählt. Vorzugsweise sind die Mikro-Säulen-Längsausdehnungen (Fadenlängen) einer Vielzahl der Mikro-Säulen bzw. aller Mikro-Säulen aus den genannten Bereichen. Dabei können die Mikro-Säulen gleich lang sein. Denkbar ist auch, dass die Mikro-Säulen einer Mikro-Struktur unterschiedlich lang sind, also unterschiedliche Mikro-Säulen-Längsausdehnungen aufweisen.

Vorzugsweise werden zum Anordnen des Mikro-Säulen-Materials folgende weiteren Verfahrensschritte durchgeführt: d) Einbringen von Ausgangs-Material des Mikro-Säulen-Materials in die Schablonen-Hohlräume und e) Umwandeln des Ausgangs-Materials des Mikro-Säulen-Materials in das Mikro-Strukturmaterial.

Das amorphe Mikro-Säulen-Material ist ein nicht einkristallines Material. Beispielsweise ist das Mikro-Säulen-Material nicht-kristallin. Dabei ist als Mikro-Säulen-Material jedes beliebige Material denkbar, beispielsweise Metalle, Halbmetalle und beliebige anorganische und organische Verbindungen.

Mit der Erfindung wird eine bürstenartige, dreidimensional aufgebaute Mikro-Struktur bereitgestellt, die aus (systematisch) matrixartig angeordneten, extrem dünnen und gleichzeitig selbst-tragenden Mikro-Säulen (Fäden, Nadeln) besteht. Die Mikro-Struktur ist selbst-tragend. Sie bedarf keiner Auflage-Fläche zum Stützen der Mikro-Struktur. Die Mikro-Struktur weist ein Raster mit Raster-Punkten auf. Die Raster-Punkte werden von den Mikro-Säulen gebildet. Eine derartige Mikro-Struktur weist zudem eine extrem große Oberfläche auf. Bisher gibt es kein Verfahren dafür, eine solche Mikro-Struktur herzustellen, die ein Faden-Raster von kleiner 10 µm bei einer Fadenlänge von bis zu 1000 µm und mehr aufweist.

Die grundlegende Idee zur Herstellung der Mikro-Struktur besteht darin, basierend auf einer Schablone (Matrix, Template) eine zur Mikro-Struktur inverse Schablonen-Struktur (Matrix-Struktur) mit Schablonen-Hohlräumen bereitzustellen. Die Schablonen-Hohlräume sind bezüglich ihrer Schablonen-Hohlraum-Längsdehnungen im Wesentlichen parallel zueinander ausgerichtet und weisen jeweils einen Schablonen-Hohlraum-Durchmesser aus dem Bereich von 0,1 µm bis 200 µm auf. Entsprechend der Mikro-Struktur beträgt auch ein Abstand zwischen den benachbarten Schablonen-Hohlräumen 1 µm bis 100 µm.

Der Schablonen-Hohlraum-Durchmesser entspricht dem Mikro-Säulen-Durchmesser und die Schablonen-Hohlraum-Längsausdehnung der Mikro-Säulen-Längsausdehnung. Auch die Aspekt-Verhältnisse der Mikro-Säulen und der Schablonen-Hohlräume stimmen überein. Allgemein ist das AspektVerhältnis einer Struktur das Verhältnis der Höhe der Struktur zu einer lateralen Ausdehnung der Struktur, bezüglich eines Schablonen-Hohlraums also das Verhältnis der Schablonen-Hohlraum-Längsausdehnung zu einem (gemittelten) Schablonen-Hohlraum-Längsausdehnung zu einem (gemittelten) Schablonen-Hohlraum-Durchmesser und bezüglich einer Mikro-Säule also das Verhältnis der Mikro-Säulen-Längsausdehnung zu seinem (gemitteltem) Mikro-Säulen-Durchmesser.

Die Schablonen-Hohlräume werden beispielsweise mit flüssigem Mikro-Säulen-Material als Ausgangs-Material oder einem anderen flüssigen Ausgangs-Material des Mikro-Säulen-Materials befüllt. Nachfolgend kommt es in den Schablonen-Hohlräumen zur Umsetzung des flüssigen Materials in das feste Mikro-Säulen-Material. Es bilden sich die Mikro-Säulen.

Beispielsweise wird bei erhöhter Temperatur flüssiges Metall als Ausgangs-Material in die Schablonen-Hohlräume eingebracht. Anschließend wird die Temperatur erniedrigt. Das flüssige Metall erstarrt und es entstehen die entsprechenden Mikro-Säulen aus dem Metall.

Denkbar ist auch, dass die Schablonen-Hohlräume als Mikro-Reaktoren fungieren. Dabei wird flüssiges Ausgangs-Material in die Schablonen-Hohlräume eingebracht. Eine anschließende chemische Reaktion führt zur Bildung des Mikro-Säulen-Materials. Es entstehen die Mikro-Säulen.

Nach der Bildung der Mikro-Säulen wird das Schablonen-Material zumindest zum Teil entfernt. Dies bedeutet, dass die Mikro-Säulen teilweise oder vollständig freigelegt werden.

Gemäß einer besonderen Ausgestaltung des Verfahrens wird eine Schablone mit Silizium als Schablonen-Material verwendet. Beispielsweise wird das Verfahren mit Hilfe eines Silizium-Wafers durchgeführt. Der Silizium-Wafer fungiert als Schablone. Silizium eignet sich besonders gut für die Erzeugung der oben beschriebenen säulenartigen Schablonen-Hohlräume mit den notwendigen Aspekt-Verhältnissen. Dazu wird der PAECE (Photo Assisted Electro-Chemical Etching)-Prozess durchgeführt. Ausgangspunkt dieses Verfahrens ist ein Einbringen von "Ätz-Grübchen" (etch pits) in eine Oberfläche des Silizium-Wafers, beispielsweise durch Photolithographie. Dieser oberflächenstrukturierte Silizium-Wafer wird einer Ätz-Lösung mit Fluss-Säure ausgesetzt. Durch Einwirken eines elektrischen Feldes und durch Bestrahlen mit Licht entstehen ausgehend von den "Ätz-Grübchen" mit einer extremen Struktur-Treue die säulenartigen Schablonen-Hohlräume.

In einer weiteren Ausgestaltung wird eine Schablone mit einem Träger mit Träger-Material für die Mikro-Struktur verwendet. Im Ergebnis ist die Vielzahl von Mikro-Säulen auf einem gemeinsamen Träger mit dem Träger-Material angeordnet. Dabei kann das Träger-Material elastisch sein, beispielsweise ein Elastomer. Beispielsweise ist der Träger ein Gummiband. Nach dem Entfernen des Schablonen-Materials ist die Mikro-Struktur nur mehr auf dem Träger angeordnet. Das Gummiband kann elastisch verformt werden. Denkbar ist aber auch, dass das Träger-Material inelastisch ist. Beispielsweise fungiert der oben beschriebene Silizium-Wafer nicht nur als Schablone, sondern auch als Träger. Nach dem Herstellen der Mikro-Struktur wird das Silizium des Silizium-Wafers nur zum Teil entfernt. Der verbleibende Silizium-Wafer dient als Träger. Das Träger-Material weist das Schablonen-Material auf, in diesem Fall Silizium.

Nach dem Entfernen des Schablonen-Materials kann eine Funktions-Schicht mit Funktions-Material an den Enden der Mikro-Säulen angeordnet werden. Es wird dafür gesorgt, dass an den Enden zumindest eines Teils der Mikro-Säulen eine Funktions-Schicht mit Funktions-Material angeordnet ist. Die Funktions-Schicht kann beliebige Funktionen übernehmen. Beispielsweise kann die Funktions-Schicht eine Schutzschicht zum Schützen der Mikro-Struktur sein. Die Funktions-Schicht kann als Stütz-Schicht fungieren. Die Funktions-Schicht kann auch als mechanische Funktions-Schicht derart ausgelegt sein, dass die Mikro-Struktur als Verbindungs-Element verwendet werden kann, beispielsweise als Verbindungs-Element eines Klettverschlusses. Denkbar sind aber auch andere Funktions-Schichten. So kann die Funktions-Schicht eine Isolations-Schicht mit einem dielektrischen Funktions-Material sein. Denkbar ist auch eine elektrisch leitfähige Funktions-Schicht mit elektrisch leitfähigem Funktions-Material. Eine derartige Funktions-Schicht verbindet beispielsweise die Mikro-Säulen elektrisch leitend miteinander.

Zumindest eine der Mikro-Säulen weist mindestens zwei entlang der Mikro-Säulen-Längsausdehnung angeordnete Abschnitte mit voneinander unterschiedlichen amorphen Mikro-Säulen-Materialien auf. Beispielsweise besteht die Mikro-Säule aus zwei Abschnitten (Teil-Abschnitten) mit unterschiedlichen Mikro-Säulen-Materialien. Dies wird beispielsweise dadurch erreicht, dass die Schablonen-Hohlräume zunächst mit einem ersten Mikro-Säulen-Material teilweise befüllt werden. Nach dem Ausbilden der entsprechenden Teil-Mikro-Säulen werden die frei gebliebenen Bereiche der Schablonen-Hohlräume mit einem zweiten Mikro-Säulen-Material befüllt. Nachfolgendes Umsetzen in das zweite Mikro-Säulen-Material führt dazu, dass eine Mikro-Säule mit zwei Abschnitten aus unterschiedlichen Mikro-Säulen-Materialien entsteht. Denkbar ist auch, dass die Schablonen-Hohlräume mit den beiden Mikro-Säulen-Materialien von unterschiedlichen Seiten her befüllt werden und in einem einzigen gemeinsamen Prozess in die jeweiligen Mikro-Säulen-Materialien überführt werden.

Denkbar ist aber auch, dass eine heterogene, aus unterschiedlichen Mikro-Säulen-Materialien aufgebaute Mikro-Struktur vorhanden ist. Gemäß einer besonderen Ausgestaltung weisen daher mindestens zwei der Mikro-Säulen von einander unterschiedliche amorphen Mikro-Säulen-Materialien auf. Dies lässt sich beispielsweise dadurch bewerkstelligen, dass während des Anordnens eines der Mikro-Säulen-Materialien ein Teil der Schablonen-Hohlräume abgedeckt wird. Anschließend werden die abgedeckten Schablonen-Hohlräume mit einem anderen Mikro-Säulen-Material füllt. Die Mikro-Säulen-Materialien können wieder gleichzeitig in einem gemeinsamen Prozess zu den entsprechenden Mikro-Säulen umgesetzt werden. Es resultiert eine Mikro-Struktur mit Mikro-Säulen mit unterschiedlichen Mikro-Säulen-Materialien. Denkbar ist aber auch eine serielle Herstellung dieser Mikro-Säulen. Dies bedeutet, dass zunächst das erste Mikro-Säulen-Material umgesetzt wird, bevor das zweite Mikro-Säulen-Material in die zuvor abgedeckten Schablonen-Hohlräume eingefüllt und anschließend umgesetzt wird.

In einer weiteren Ausgestaltung weist zumindest eine der Mikro-Säulen mindestens eine Umhüllung mit mindestens einem Umhüllungs-Material auf. Das Umhüllungs-Material der Umhüllung und das Mikro-Säulen-Material der Mikro-Säule unterscheiden sich. Die Umhüllung ist zum Beispiel fest mit der Mikro-Säule verbunden. Die Mikro-Säule bildet einen Kern, der von der Umhüllung umgeben ist. Dabei kann die Mikro-Säule nur zum Teil von der Umhüllung umgeben sein, beispielsweise an den Enden der Mikro-Säule. Auch kann die Umhüllung nicht nur aus einer Schicht bestehen, sie kann auch mehrschichtig sein. Mit Hilfe der Umhüllung kann beispielsweise eine Form der Mikro-Säule angepasst werden. Eine Umhüllung, die lediglich an den Enden einer Mikro-Säule angeordnet ist, führt zu einer Verdickung der Enden der Mikro-Säule.

Aufgebracht werden kann die Umhüllung beispielsweise durch elektrochemische Abscheidung (für den Fall, dass das Mikro-Säulen-Material elektrisch leitfähig ist). Denkbar ist auch, dass das Umhüllungs-Material über ein Gas-Phasen-Abscheide-Verfahren auf der Oberfläche der Mikro-Säulen aufgebracht wird. Das Gas-Phasen-Abscheide-Verfahren ist beispielsweise ein Dampfabscheideverfahren. Ein PVD (Physikal Vapour Deposition)-Verfahren, wie Sputtern, oder ein CVD (Chemical Vapour Deposition)-Verfahren ist ebenfalls denkbar.

In einer weiteren Ausgestaltung ist im Mikro-Säulen-Zwischenraum zwischen den benachbarten Mikro-Säulen mindestens ein Zwischenraum-Material angeordnet. Gemäß einer weiteren Ausgestaltung bildet das Zwischenraum-Material eine zusammenhängende Zwischenraum-Schicht, über die die benachbarten Mikro-Struktur-Säulen fixiert sind. Das Zwischenraum-Material ist beispielsweise mit den Mikro-Säulen nicht fest verbunden. Es dient lediglich dazu, die Mikro-Säulen zusammenzuhalten.

Es kann lediglich eine einzige, zusammenhängende Zwischenraum-Schicht vorhanden sein. Denkbar ist auch, dass im Mikro-Säulen-Zwischenraum zwischen den benachbarten Mikro-Säulen mindestens zwei Zwischenraum-Materialien angeordnet sind, die jeweils mindestens eine zusammenhängende Schicht bilden. Es resultiert eine mehrschichtige Zwischenraum-Schicht.

In einer weiteren Ausgestaltung weist zumindest eine der Mikro-Säulen einen Mikro-Säulen-Hohlraum auf. Die Mikro-Säule weist eine Mikro-Säulen-Wandung auf. Im Inneren der Mikro-Säulen-Wandung ist die Mikro-Säule hohl. Die Mikro-Säule ist als Hohlnadel ausgestaltet. Der Mikro-Säulen-Hohlraum führt zu einer weiteren Vergrößerung der Oberfläche der Mikro-Struktur. Der Mikro-Säulen-Hohlraum erstreckt sich dabei vorzugsweise entlang der gesamten Mikro-Säulen-Längsausdehnung. Denkbar ist aber auch, dass sich der Mikro-Säulen-Hohlraum nur teilweise entlang der Mikro-Säulen-Längsausdehnung erstreckt. Die Mikro-Säule ist nur zum Teil als Hohlnadel ausgestaltet.

Weiterhin ist es möglich, dass Mikro-Säulen-Oberflächen der Mikro-Säulen strukturiert sind. Dazu weist zumindest eine der Mikro-Säulen einen entlang der Mikro-Säulen-Längsausdehnung der Mikro-Säule variierenden Mikro-Säulen-Durchmesser auf. Eine Variation des Mikro-Säulen-Durchmessers gelingt beispielsweise durch Variation des beim PAECE-Verfahren eingesetzten elektrischen Stromes.

Beispielsweise nimmt der Mikro-Säulen-Durchmesser kontinuierlich in eine Richtung zu oder ab. Die Mikro-Säule läuft konisch zu. Denkbar ist auch, dass der Mikro-Säulen-Durchmesser periodisch variiert. Denkbar ist auch, dass die Mikro-Säulen-Durchmesser an den Enden der Mikro-Säulen höher sind als in der Mitte der Mikro-Säulen. Es resultieren Mikro-Säulen, die an ihren Enden verdickt sind. In allen der hier beschriebenen Ausführungsformen wird zur Berechnung des Aspekt-Verhältnisses ein gemittelter Mikro-Säulen-Durchmesser herangezogen.

Die vorgestellten Mikro-Strukturen können in verschiedensten Bereichen eingesetzt werden, abhängig unter anderem von den verwendeten Mikro-Säulen-Materialien, vorhandenen Funktions-Schichten oder den verwendeten Träger der Mikro-Strukturen.

So wird die Mikro-Struktur, bei dem das Mikro-Säulen-Material elektrisch leitfähig ist, beispielsweise als Elektrode eingesetzt. Für die elektrische Verbindung zwischen den Mikro-Säulen sorgt beispielsweise ein Träger oder eine Funktions-Schicht mit elektrisch leitfähigem Material. Es resultiert eine Elektrode mit extrem großer Oberfläche. Diese Elektrode wird beispielsweise in einem Kondensator verwendet.

Denkbar ist auch, dass mit Hilfe der Funktions-Schicht ein Thermoelement realisiert ist. Die Mikro-Struktur wird zur Detektion von Wärmestrahlung eingesetzt. Aufgrund der feinen Rasterung der Mikro-Struktur kann die Wärmestrahlung mit hoher Ortsauflösung detektiert werden.

Eine Mikro-Struktur mit entsprechenden Verdickungen an den Enden der Mikro-Säulen kann dagegen als mechanisches Verbindungs-Element verwendet werden.

Zusammenfassend ergeben sich mit der Erfindung folgende Vorteile:
- Es ist eine Mikro-Struktur zugänglich, die eine extrem hohe Oberfläche aufweist.
- Die Mikro-Struktur weist selbst-tragende Mikro-Säulen auf. Sie bedarf daher keiner Auflagefläche zum Stützen Mikro-Struktur.
- Die Mikro-Struktur kann gezielt und kontrolliert hergestellt werden.
- Es gibt viele Möglichkeiten, die Eigenschaften der Mikro-Struktur zu verändern. So können die Mikro-Strukturen an eine Vielzahl möglicher Anwendungen angepasst werden.

Anhand mehrerer Ausführungsbeispiele und der dazugehörigen Figuren wird die Erfindung im Folgenden näher beschrieben. Die Figuren sind schematisch und stellen keine maßstabsgetreuen Abbildungen dar.
- Figuren 1 und 2: zeigen jeweils eine Mikro-Struktur von der Seite.
- Figur 3: zeigt eine Mikro-Struktur in perspektivischer Darstellung.
- Figur 4: zeigt das grundlegende Verfahren zum Herstellen der Mikro-Struktur.
- Figur 5: zeigt ein Verfahren zum Befüllen von SchablonenHohlräumen einer Schablone.
- Figur 6: zeigt ein Verfahren zum Anordnen einer Mikro-Struktur auf einem Träger.
- Figur 7: zeigt eine Mikro-Struktur auf einem elastischen Träger.
- Figur 8: zeigt ein Verfahren zum Herstellen einer MikroStruktur mit Zwischenraumschicht.
- Figuren 9 und 10: zeigen Verfahren zum Herstellen von MikroStrukturen mit strukturierten Mikro-Säulen.
- Figur 11: zeigt ein Verfahren zum Herstellen einer MikroStruktur aus Mikro-Säulen mit unterschiedlichem Mikro-Säulen-Material.
- Figur 12: zeigt Verfahren zum Herstellen einer Mikro-Struktur mit hohlen Mikro-Säulen.
- Figur 13: zeigt ein Verfahren zum Herstellen einer MikroStruktur, bei der jede der Mikro-Säulen mehrere unterschiedliche Mikro-Säulen-Materialien aufweist.
- Figur 14: zeigt ein Verfahren, bei dem eine Mikro-Struktur mit verschiedenen Mikro-Struktur-Bereichen hergestellt wird.
- Figur 15: zeigt ein Diagramm mit der Abhängigkeit der MikroSäulen-Oberfläche von der Mikro-SäulenLängsausdehnung bei unterschiedlichen Mikro-SäulenDurchmessern.
- Figur 16: zeigt zwei benachbarte Mikro-Säulen einer MikroStruktur.

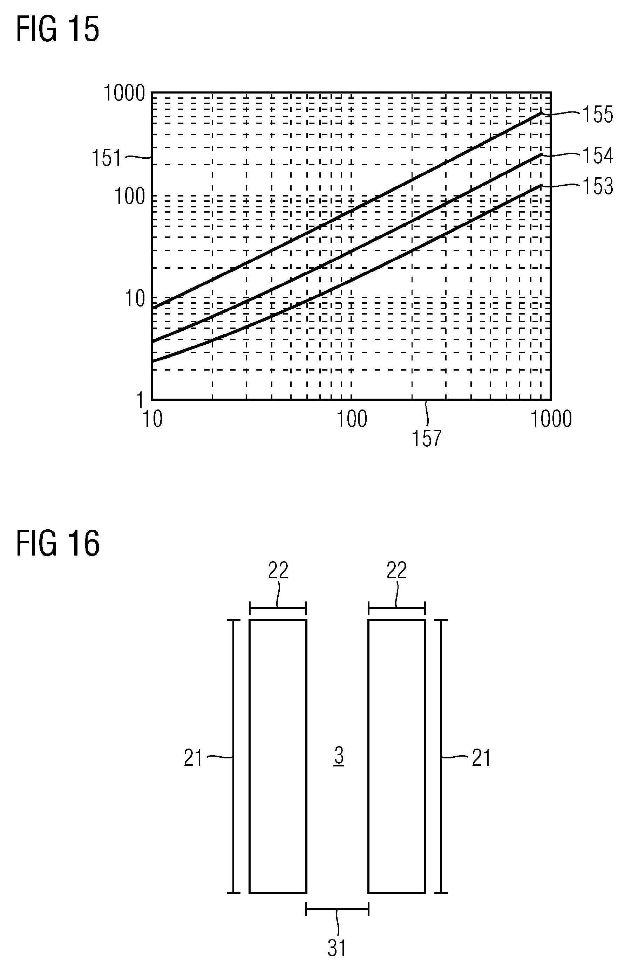

Gegenstand der nachfolgenden Beispiele ist jeweils eine dreidimensionale Mikro-Struktur 1, aufweisend eine Vielzahl von nebeneinander bezüglich ihrer jeweiligen Mikro-Säulen-Längsausdehnung 21 im Wesentlichen parallel zueinander und voneinander beabstandet angeordnete Mikro-Säulen 2 mit mindestens einem Mikro-Säulen-Material 20, die jeweils einen Mikro-Säulen-Durchmesser 22 (vgl. Figur 16) aus dem Bereich von 0,1 µm bis 200 µm aufweisen. Zwischen benachbarten Mikro-Säulen ist ein Mikro-Säulen-Zwischenraum 3 vorhanden. Der Mikro-Säulen-Zwischenraum weist einen Mikro-Säulen-Abstand 31 zwischen benachbarten Mikro-Säulen aus dem Bereich von 1 µm bis 100 µm auf.

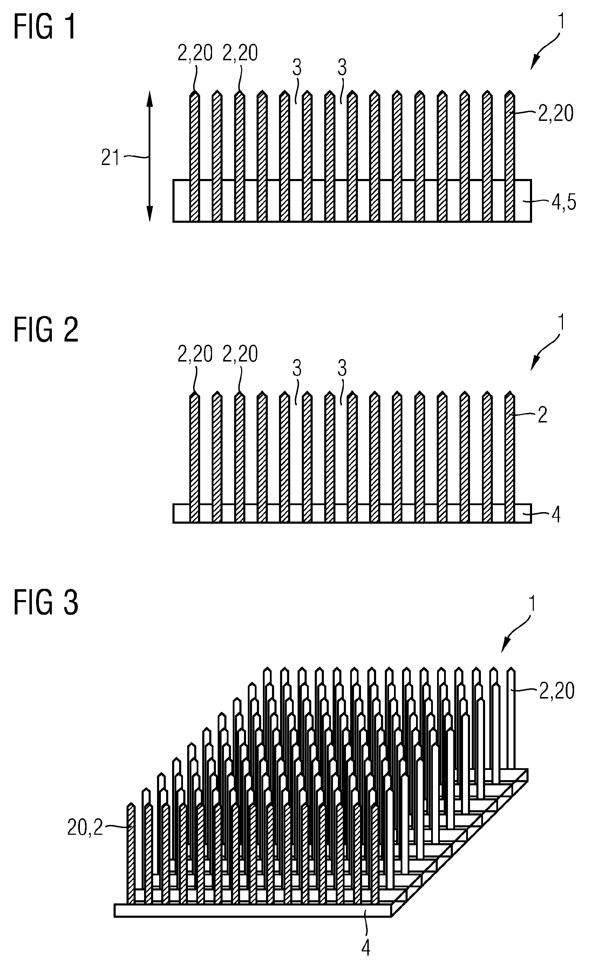

Die Mikro-Struktur ist mit einem Träger (Substrat) 4 verbunden, der aus der verwendeten Schablone 5 durch teilweises Entfernen des Schablonen-Materials hervorgeht (Figur 1). In einer alternativen Ausführungsform verbleibt die Mikro-Struktur auf einem Träger 4, der im Verlauf des Herstellungsverfahrens mit der Schablone verbunden wurde. Das Schablonen-Material wird vollständig entfernt. Übrig bleibt die Mikro-Struktur auf dem Träger (Figuren 2 und 3).

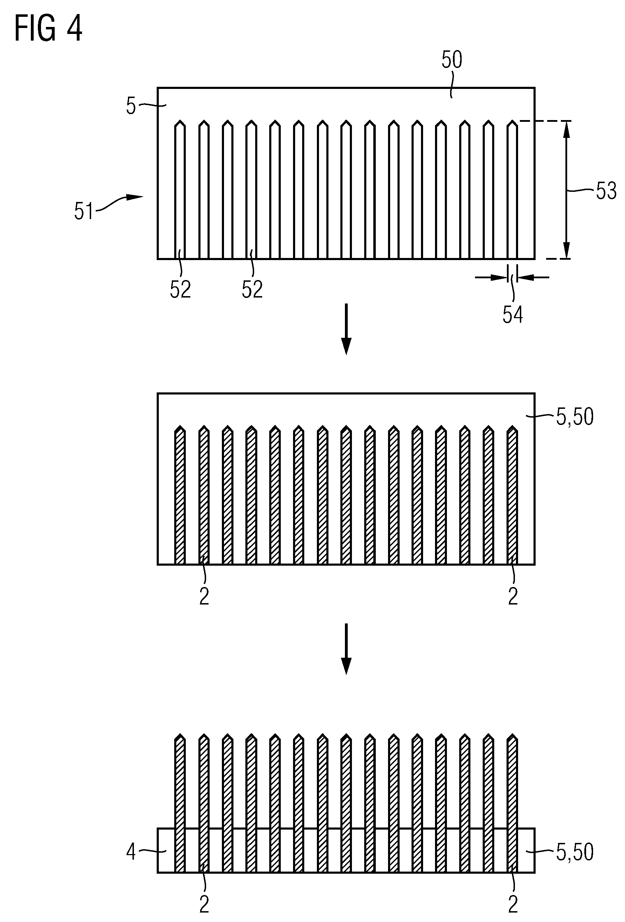

Zum Herstellen der dreidimensionalen Mikro-Struktur werden folgende Verfahrensschritte durchgeführt (Figur 4): a) Bereitstellen einer Schablone 5 mit Schablonen-Material 50, wobei die Schablone eine im Wesentlichen zur Mikro-Struktur inverse, dreidimensionale Schablonenstruktur 51 mit säulenartigen Schablonen-Hohlräumen 52 aufweist, b) Anordnen von Mikro-Säulen-Material in den säulenartigen Schablonen-Hohlräumen, so dass die Mikro-Säulen entstehen, und c) zumindest teilweises Entfernen des Schablonen-Materials.

Ausgangspunkt ist ein Silizium-Wafer. Dieser Silizium-Wafer dient als Schablone. Das Schablonen-Material ist Silizium. Mit Hilfe des PAECE-Prozesses werden die Schablonen-Hohlräume in den Silizium-Wafer eingebracht. Die Schablonen-Hohlräume werden mit Hohlraum-Längsausdehnung 53 und Hohlraum-Durchmesser 54 eingebracht, die den herzustellenden Mikro-Säulen entsprechen. Auch die Abstände zwischen den Schablonen-Hohlräumen werden entsprechen der Abständen der Mikro-Säulen gewählt.

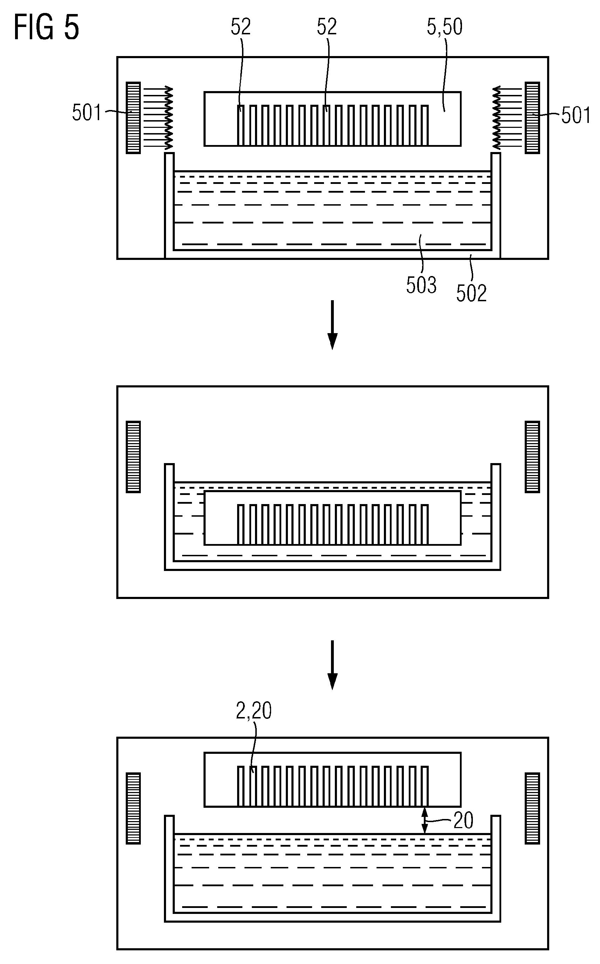

Nachfolgend werden die säulenartigen Schablonen-Hohlräume mit flüssigem Mikro-Säulen-Material befüllt. Dieses Vorgehen ist beispielhaft in Figur 5 dargestellt: Die Schablone mit den Schablonen-Hohlräumen wird mit Hilfe der Heiz-Elemente 501 erwärmt und in ein Reservoir 502 mit flüssigem Metall 503 getaucht. Durch Variation eines äußeren Drucks wird dafür gesorgt, dass das flüssige Metall in die Schablonen-Hohlräume eindringt. Anschließend wird die Schablone mit den gefüllten Schablonen-Hohlräumen aus dem Reservoir entfernt. Die Schablone kühlt ab. Also Folge davon erstarrt das Metall in den Schablonen-Hohlräumen. Es entstehen die Mikro-Säulen aus dem Metall. Das flüssige Metall dient als Ausgangs-Material des Mikro-Säulen-Materials. Es wird durch Abkühlung in das Mikro-Säulen-Material (festes Metall) überführt.

### Beispiel 1:

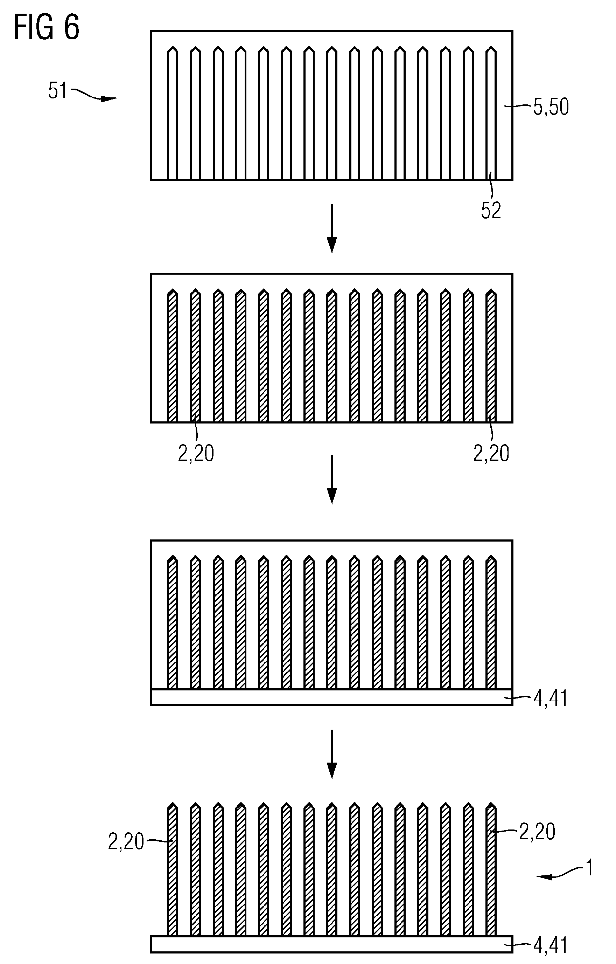

Es wird eine Mikro-Struktur auf einem Träger 4 hergestellt (Figur 6). Dazu wird eine Schablone mit Schablonen-Struktur mit Schablonen-Hohlräumen bereitgestellt, in denen, wie oben beschrieben, Mikro-Säulen mit Mikro-Säulen-Material angeordnet werden. Anschließend wird daran ein Träger angeordnet, so dass die Mikro-Säulen mit dem Träger verbunden werden. Nachfolgend wird das Schablonen-Material nahezu vollständig entfernt. Es verbleibt die Mikro-Struktur mit den auf dem Träger angeordneten Mikro-Säulen.

Gemäß diesem Beispiel ist der Träger aus einem starren Träger-Material 41. Das Träger-Material ist eine Keramik. In einer alternativen Ausführungsform ist das Träger-Material ein Metall.

### Beispiel 2:

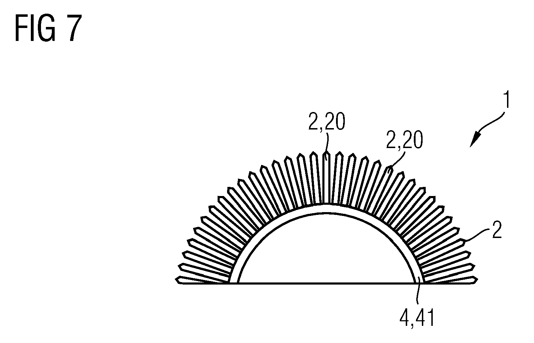

Im Gegensatz zum Beispiel 1 wird ein Träger mit elastomerem Träger-Material verwendet. Das elastomere Träger-Material ist Gummi. Der Träger aus Gummi kann elastisch verformt werden (Figur 7).

### Beispiel 3:

Gemäß diesem Beispiel wird in den Mikro-Säulen-Zwischenräumen Zwischenraum-Material 33 angeordnet. Das Zwischenraum-Material bildet eine Zwischenraum-Schicht 32, mit deren Hilfe die Mikro-Säulen fixiert, d.h. aneinander gehalten werden.

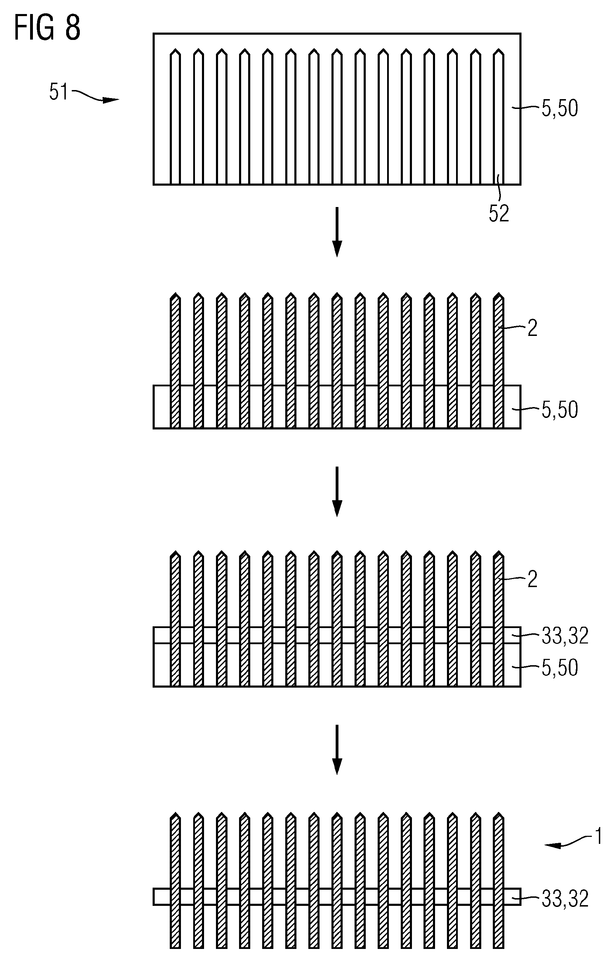

Dazu wird nach dem Bilden der Mikro-Säulen in den Schablonen-Hohlräumen das Schablonen-Material teilweise entfernt (Figur 8). Anschließend wird das Zwischenraum-Material derart in den Zwischenräumen zwischen den benachbarten Mikro-Säulen angeordnet, dass sich die Zwischenraum-Schicht bildet. Schließlich wird das restliche Schablonen-Material entfernt. Übrig bleibt die Mikro-Struktur, deren Mikro-Säulen über die Zwischenraum-Schicht fixiert sind.

### Beispiel 4:

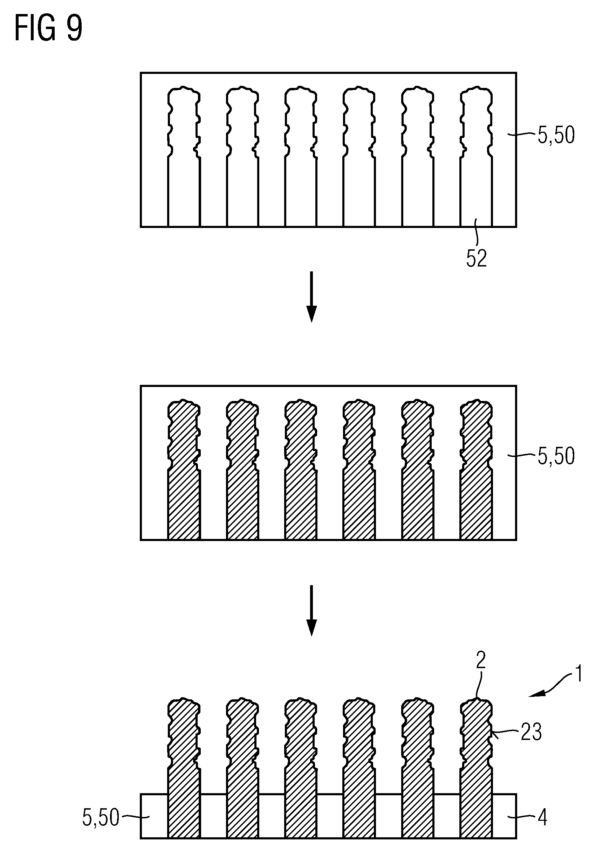

Es wird eine Mikro-Struktur mit Mikro-Säulen hergestellt, deren Mikro-Säulen-Oberflächen 23 strukturiert sind. Dazu wird eine Schablone mit Schablonen-Hohlräumen verwendet, die entlang der Schablonen-Hohlraum-Längsausdehnung variierende Schablonen-Hohlraum-Durchmesser aufweisen (Figur 9).

Nach Anordnen des entsprechenden Mikro-Säulen-Materials in den strukturierten Schablonen-Hohlräumen und teilweises Entfernen des Schablonen-Materials resultiert eine Mikro-Struktur mit Mikro-Säulen, die strukturierte Mikro-Säulen-Oberflächen aufweisen. Die verbleibende Schablone fungiert als Träger.

### Beispiel 5:

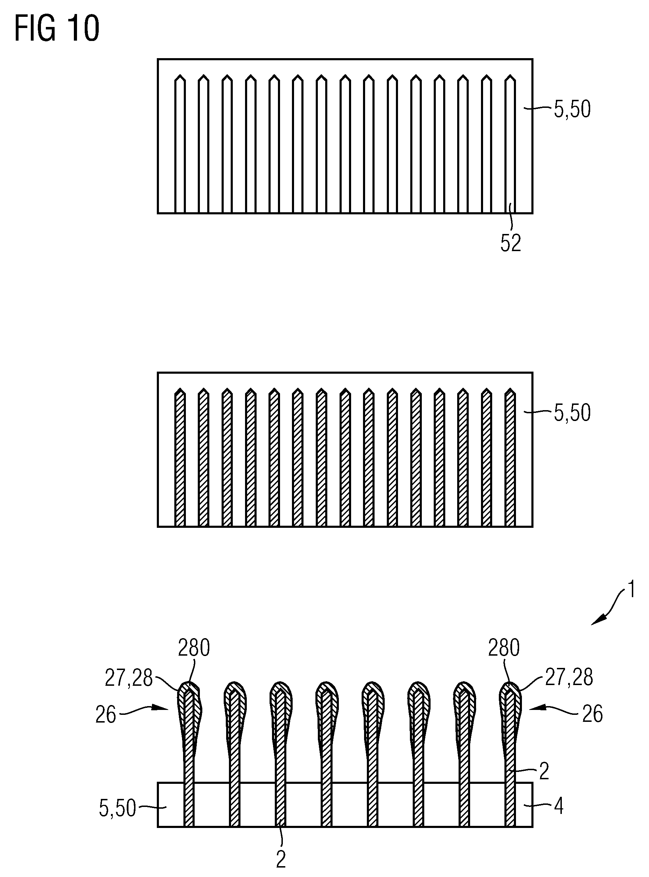

Es wird eine Mikro-Struktur hergestellt, bei dem an den Enden 26 der Mikro-Säulen Umhüllungen 27 angeordnet sind (Figur 10). Auch hier sind die Mikro-Säulen-Oberflächen strukturiert. Die Umhüllungen werden nach dem teilweisen Entfernen des Schablonen-Materials in einem PVD-Verfahren aufgebracht. Die Umhüllungen fungieren als Funktions-Schicht 28. Je nach gewünschter Funktion, werden beliebige Funktions-Schichten mit verschiedensten Funktions-Materialien 280 aufgebracht.

So kann eine Mikro-Struktur mit Mikro-Säulen, die an den Enden verdickt sind, als Verbindungs-Element eingesetzt werden. Durch Ineinander-Anordnen zweier derartiger Mikro-Strukturen wird ein kraftschlüssiger Kontakt zwischen den beiden Mikro-Strukturen erzeugt. Dabei ragen die Mikro-Säulen der einen Mikro-Struktur in die Mikro-Säulen-Zwischenräume der anderen Mikro-Struktur und umgekehrt.

In einer dazu alternativen Ausführungsform werden die Umhüllungen durch elektrochemische Abscheidung aufgebracht. Dazu ist das Mikro-Säulen-Material elektrisch leitfähig. Die Mikro-Säulen fungieren beispielsweise als Kathode, an deren Mikro-Säulen-Oberflächen ein Metall wie Kupfer elektrochemisch abgeschieden wird. In diesem Fall ist die Mikro-Struktur als Elektrode ausgestaltet. Diese Elektrode kann als Kondensatorelektrode eines Kondensators eingesetzt werden.

### Beispiel 6:

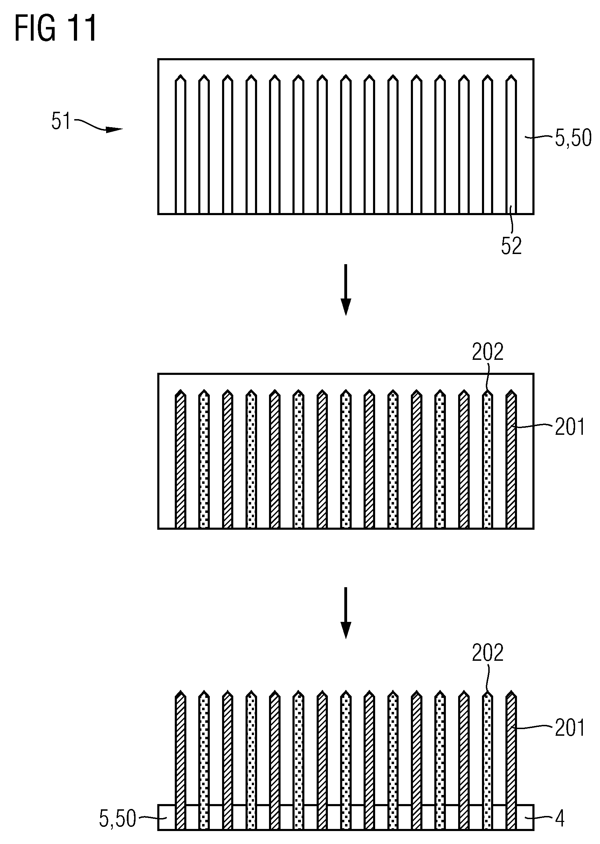

Es wird eine Mikro-Struktur mit Mikro-Säulen hergestellt, die von Mikro-Säule zu Mikro-Säule unterschiedliche Mikro-Säulen-Materialien 201 und 202 aufweisen (Figur 11). Die Mikro-Struktur weist Mikro-Säulen mit Mikro-Säulen-Material 201 und Mikro-Säulen mit weiterem Mikro-Säulen-Material 202 auf, das sich vom Mikro-Säulen-Material unterscheidet.

Dazu werden die Schablonen-Hohlräume mit unterschiedlichen Ausgangs-Materialien der verschiedenen Mikro-Säulen-Materialien befüllt. Dies gelingt dadurch, dass die jeweils nicht zu befüllenden Schablonen-Hohlräume abgedeckt werden.

Nach Umsetzen der Ausgangs-Materialien in die Mikro-Säulen-Materialien wird wieder das Schablonen-Material teilweise entfernt. Es verbleibt der Rest der Schablone als Träger einer Mikro-Struktur mit zwei Gruppen von Mikro-Säulen mit unterschiedlichen Mikro-Säulen-Materialien.

### Beispiel 7:

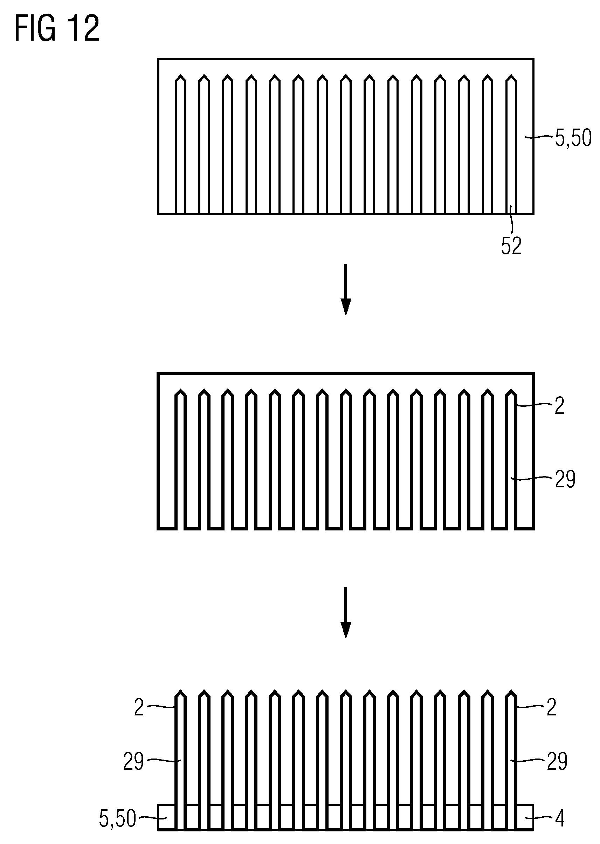

Es wird eine Mikro-Struktur mit Mikro-Säulen hergestellt, die Mikro-Struktur-Hohlräume 29 aufweisen. Die Mikro-Struktur weist aus Hohl-Nadeln auf (Figur 12).

Dazu werden die Schablonen-Hohlräume mit dem Ausgangs-Material des Mikro-Säulen-Materials ausgekleidet. Das Ausgangs-Material wird nur an einer Hohlraum-Oberfläche angeordnet. Nachfolgendes Umsetzen des Ausgangs-Materials führt zu Mikro-Säulen, die über eine Mikro-Säulen-Wandung aus dem Mikro-Säulen-Material verfügen. Ansonsten sind die Mikro-Säulen hohl.

Nachfolgend wird das Schablonen-Material wieder teilweise entfernt. Es verbleibt eine Mikro-Struktur mit Mikro-Säulen in Form von Hohlnadeln, die auf einem Substrat aus dem Schablonen-Material angeordnet sind.

### Beispiel 8:

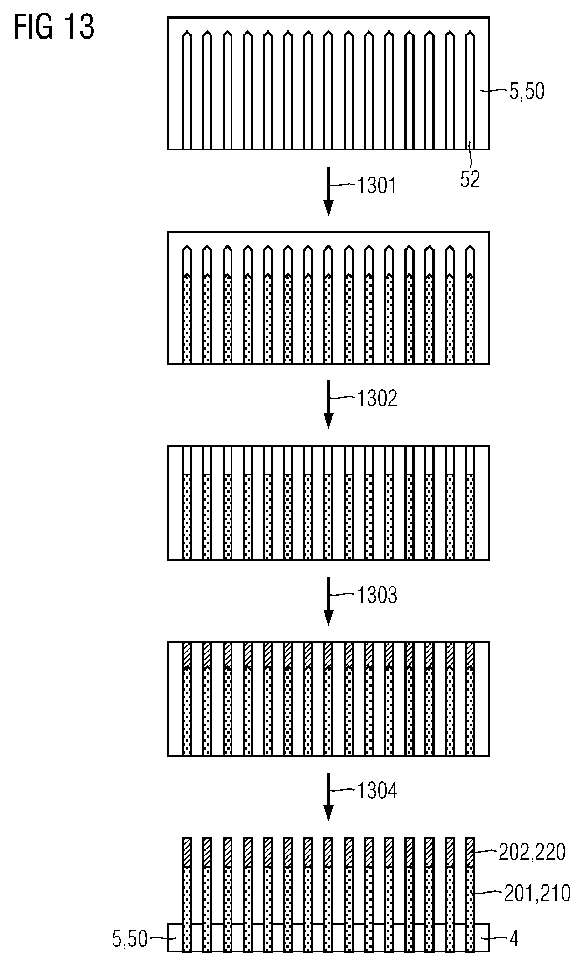

Es wird eine Mikro-Struktur hergestellt, bei der die einzelnen Mikro-Säulen unterschiedliche Mikro-Säulen-Materialien aufweisen. Entlang der Mikro-Säulen-Längsausdehnung sind ein Abschnitt 210 mit Mikro-Säulen-Material 201 und ein weiterer Abschnitt 220 mit gegenüber dem Mikro-Säulen-Material unterschiedlichem weiteren Mikro-Säulen-Material 202 vorhanden (Figur 13).

Ausgehend von der Schablone 5 werden die Schablonen-Hohlräume von deren offener Seite her zunächst mit dem Ausgangs-Material eines der Mikro-Säulen-Materialien befüllt. Nach Umsetzung des Ausgangs-Materials in das entsprechende Mikro-Säulen-Material (Schritt 1301) wird von der geschlossenen Seite der Schablone soweit Schablonen-Material abgetragen, dass die Schablonen-Hohlräume freigelegt werden (Schritt 1302). Anschließend wird Ausgangs-Material für das weitere, vom Mikro-Säulen-Material unterschiedliche Mikro-Säulen-Material befüllt und zum entsprechenden Mikro-Säulen-Material umgesetzt (Schritt 1303). Schließlich wird das Schablonen-Material wieder teilweise entfernt (Schritt 1304).

### Beispiel 9:

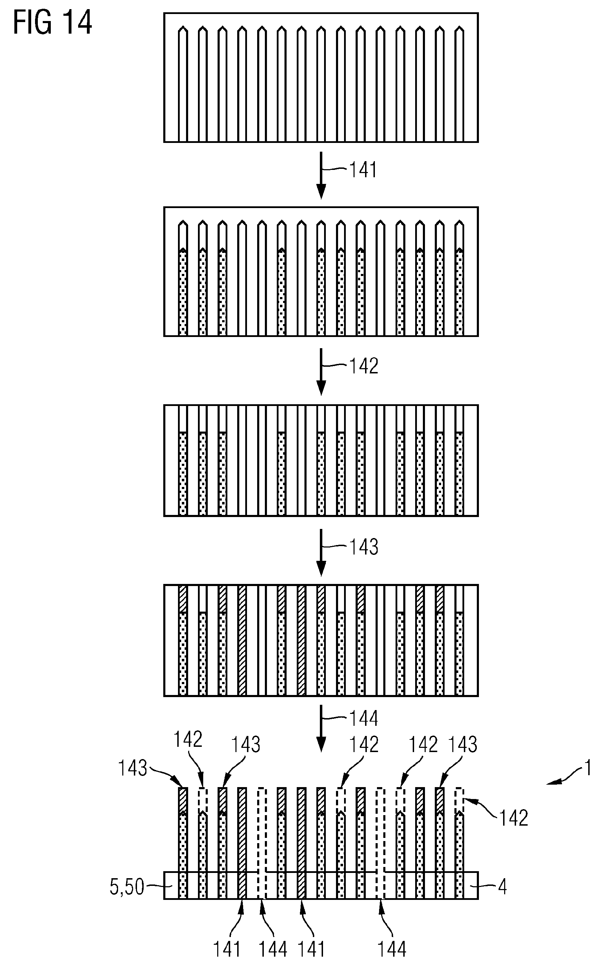

Dieses Beispiel stellt eine Kombination der zuvor beschriebenen Beispiele dar. Durch eine geeignete Abfolge der zuvor beschriebenen Prozess-Schritte gelingt es, eine Mikro-Struktur herzustellen, die über verschiedene Bereiche verfügt (Figur 14): Mikro-Säulen 141, 142 mit jeweils nur einer Art von Mikro-Säulen-Material, die aber zueinander unterschiedlich sind. Zudem sind die Mikro-Säulen 141 und 142 unterschiedlich lang. Sie verfügen über unterschiedliche Mikro-Säulen-Längsausdehnungen. Darüber hinaus gibt es Mikro-Säulen 143, die entlang ihrer Mikro-Säulen-Längsausdehnung unterschiedliche Mikro-Säulen-Materialien aufweisen. Schließlich gibt es Bereiche 144, in denen überhaupt keine Mikro-Säulen vorhanden sind.

Zum Herstellen der beschriebenen Mikro-Struktur wird wie folgt vorgegangen: Es werden zunächst nur in ausgewählten Schablonen-Hohlräumen Mikro-Säulen mit einem ersten Mikro-Säulen-Material angeordnet (Schritt 141). Dazu werden die Schablonen-Hohlräume abgedeckt, in die nicht diese Mikro-Säulen nicht angeordnet werden sollen. In die offenen Schablonen-Hohlräume wird das Ausgangs-Material des entsprechenden Mikro-Säulen-Materials eingefüllt.

Nach Umsetzen des Ausgangs-Materials in das Mikro-Säulen-Material wird Schablone-Material von der geschlossenen Seite her entfernt (Schritt 142). Die Schablonen-Hohlräume werden freigelegt. Diejenigen Schablonen-Hohlräume werden nun abgedeckt, in denen nicht Ausgangs-Material des weiteren Mikro-Säulen-Materials eingefüllt werden soll. Nach Umsetzten dieses Ausgangs-Material in das weitere Mikro-Säulen-Material (Schritt 143) und anschließendes teilweises Entfernen des Schablonen-Materials (Schritt 144) wird eine oben beschriebene Mikro-Struktur erhalten, bei der die Mikro-Säulen auf einem Substrat aus dem Schablonen-Material angeordnet ist.

Die beschriebenen Mikro-Strukturen zeichnen sich durch extrem große Oberflächen aus. Dies verdeutlicht Figur 15. Dabei ist der Vergrößerungsfaktor 151 gegen die Mikro-Säulen-Längsausdehnung (152, Nadel-Länge) für verschiedene Mikro-Säulen-Durchmesser (Nadel-Durchmesser) und Mikro-Säulen-Abstände (Nadel-Abstände) aufgetragen. Die Kurve 153 bezieht sich auf einen Mikro-Säulen-Durchmesser von 10 µm und einem Mikro-Säulen-Abstand von 5 µm. Die Kurven 154 und 155 beziehen sich auf Werte von 5 µm und 2,5 µm beziehungsweise 2 µm und 1 µm.

## Patentansprüche

1. Verfahren zum Herstellen einer dreidimensionalen Mikro-Struktur, die eine Vielzahl von nebeneinander, bezüglich ihrer jeweiligen Mikro-Säulen-Längsausdehnung (21) im Wesentlichen parallel zueinander und voneinander beabstandet angeordnete Mikro-Säulen (2) mit mindestens einem nicht-einkristallinen Mikro-Säulen-Material (20, 201, 202), die jeweils einen Mikro-Säulen-Durchmesser (22) aus dem Bereich von 0,1 µm bis 200 µm aufweisen, und einen zwischen benachbarten Mikro-Säulen angeordneten Mikro-Säulen-Zwischenraum (3) mit einem zwischen den benachbarten Mikro-Säulen aus dem Bereich von 1 µm bis 100 µm ausgewählten Mikro-Säulen-Abstand (31) aufweist, wobei zumindest eine der Mikro-Säulen mindestens zwei entlang der Mikro-Säulen-Längsausdehnung angeordnete Abschnitte (210, 220) mit voneinander unterschiedlichen nicht-einkristallinen Mikro-Säulen-Materialien (201, 202) aufweist, mit folgenden Verfahrensschritten:
a) Bereitstellen einer Schablone (5) mit Schablonen-Material (50), wobei die Schablone eine im Wesentlichen zur Mikro-Struktur inverse, drei dimensionale Schablonen-Struktur (51) mit säulenartigen Schablonen-Hohlräumen (52) aufweist,
b) Anordnen von einem ersten Mikro-Säulen-Material und einem von dem ersten Mikro-Säulen-Material unterschiedlichen zweiten Mikro-Säulen-Material in den säulenartigen Hohlräumen, so dass die Mikro-Säulen entstehen, und zumindest eine der Mikro-Säulen mindestens zwei entlang der Mikro-Säulen-Längsausdehnung angeordnete Abschnitte (210, 220) mit voneinander unterschiedlichen nicht-einkristallinen Mikro-Säulen-Materialien (201, 202) aufweist, und
c) zumindest teilweises Entfernen des Schablonen-Materials.

2. Verfahren nach Anspruch 1, wobei zum Anordnen des Mikro-Säulen-Materials folgende weiteren Verfahrensschritte durchgeführt werden:
d) Einbringen von Ausgangs-Material des Mikro-Säulen-Materials in die Hohlräume und e) Umwandeln des Ausgangs-Materials des Mikro-Säulen-Materials in das Mikro-Strukturmaterial.

3. Verfahren nach Anspruch 1 oder 2, wobei eine Schablone mit Silizium als Schablonen-Material verwendet wird.

4. Verfahren nach einem der Ansprüche 1 bis 3, wobei eine Schablone mit einem Träger mit Träger-Material für die Mikro-Struktur verwendet wird.

5. Verfahren nach einem der Ansprüche 1 bis 4, wobei nach dem Entfernen des Schablonen-Materials eine Funktions-Schicht (28) mit Funktions-Material (280) an den Enden (26) zumindest eines Teils der Mikro-Säulen angeordnet wird.

6. Verfahren nach einem der Ansprüche 1 bis 5, wobei der Mikro-Säulen-Durchmesser aus dem Bereich von 0,3 µm bis 200 µm ausgewählt ist.

7. Verfahren nach einem der Ansprüche 1 bis 6, wobei die Mikro-Säulen-Längsausdehnung zumindest einer der Mikro-Säulen aus dem Bereich von 50 µm bis 10 mm und insbesondere aus dem Bereich von 100 µm bis 1 mm ausgewählt ist.

8. Verfahren nach einem der Ansprüche 1 bis 7, wobei mindestens zwei der Mikro-Säulen voneinander unterschiedliche nicht-kristalline Mikro-Säulen-Materialien (201, 202) aufweisen.

9. Verfahren nach einem der Ansprüche 1 bis 8, ferner folgenden Verfahrensschritt aufweisend:
Aufbringen von mindestens einer Umhüllung (27) mit mindestens einem Umhüllungs-Material auf zumindest eine der Mikro-Säulen, wobei sich das Mikro-Säulen-Material der Mikro-Säule und das Umhüllungs-Material der Umhüllung voneinander unterscheiden.

10. Verfahren nach einem der Ansprüche 1 bis 9, ferner folgenden Verfahrensschritt aufweisend:
Anordnen mindestens eines Zwischenraum-Materials (33) im Mikro-Säulen-Zwischenraum zwischen den benachbarten Mikro-Säulen.

11. Verfahren nach Anspruch 10, wobei das Zwischenraum-Material eine zusammenhängende Zwischenraum-Schicht (32) bildet, über die die benachbarten Mikro-Struktur-Säulen fixiert sind.

12. Verfahren nach Anspruch 10 oder 11, wobei im Mikro-Säulen-Zwischenraum zwischen den benachbarten Mikro-Säulen mindestens zwei Zwischenraum-Materialien angeordnet werden, die jeweils mindestens eine zusammenhängende Zwischenraum-Schicht bilden.

13. Verfahren nach einem der Ansprüche 1 bis 12, ferner folgenden Verfahrensschritt aufweisend:
Bilden eines Mikro-Säulen-Hohlraums (29) in zumindest einer der Mikro-Säulen.

14. Verfahren nach einem der Ansprüche 1 bis 13, ferner folgenden Verfahrensschritt aufweisend:
Bilden eines entlang der Mikro-Säulen-Längsausdehnung der Mikro-Säule variierenden Mikro-Säulen-Durchmessers an zumindest einer der Mikro-Säulen.

## Claims

1. Method for producing a three-dimensional micro-structure, which comprises a plurality of adjacent micro-columns (2) which are arranged at a distance from each other and substantially parallel in relation to the respective micro-column longitudinal extension (21), said micro-columns being made of at least one non-single-crystal micro-column material (20, 201, 202) having respectively a micro-column diameter (22) in the region of 0.1 µm to 200 µm, and a micro-column intermediate chamber (3) arranged between adjacent micro-columns having a micro-column distance (31) between the adjacent micro-columns selected from the region of 1 µm to 100 µm, wherein at least one of the micro-columns comprises at least two sections (210, 220) arranged along the micro-column longitudinal extension with non-single-crystal micro-column materials (201, 202) which differ from each other, with following method steps:
a) the provision of a template (5) with template material (50), wherein the template has a three-dimensional template structure (51) with column-like template cavities (52) which is substantially inverse to the micro-structure,
b) the arrangement of a first micro-column material and a second micro-column material which differs from the first micro-column material in the column-like cavities so that the micro-columns are formed and at least one of the micro-columns has at least two sections (210, 220) arranged along the micro-column longitudinal extension with non-single-crystal micro-column materials (201, 202) which differ from each other and
c) the at least partial removal of the template material.

2. Method according to claim 1, wherein the following further method steps are performed for the arrangement of the micro-column material:
d) the introduction of starting material for the micro-column material in the cavities and e) the conversion of the starting material for the micro-column material into the micro-structure material.

3. Method according to claim 1 or 2, wherein a template with silicon is used as the template material.

4. Method according to one of claims 1 to 3, wherein a template with a carrier with carrier material is used for the micro-structure.

5. Method according to one of claims 1 to 4, wherein, after the removal of the template material, a functional layer (28) with functional material (280) is arranged at the ends (26) of at least a part the micro-columns.

6. Method according to one of claims 1 to 5, wherein the micro-column diameter is selected from the region of 0.3 µm to 200 µm.

7. Method according to one of claims 1 to 6, wherein the micro-column longitudinal extension of at least one of the micro-columns is selected from the region of 50 µm to 10 mm and in particular from the region of 100 µm to 1 mm.

8. Method according to one of claims 1 to 7, wherein at least two of the micro-columns have non-crystal micro-column materials (201, 202) which differ from each other.

9. Method according to one of claims 1 to 8, having the following further method step:
the application of at least one enclosure (27) with at least one enclosure material to at least one of the micro-columns, wherein the micro-column material of the micro-columns and the enclosure material of the enclosure differ from each other.

10. Method according to one of claims 1 to 9, having the following further method step:
the arrangement of at least one intermediate chamber material (33) in the micro-column intermediate chamber between the adjacent micro-columns.

11. Method according to claim 10, wherein the intermediate chamber material forms a coherent intermediate chamber layer (32) by means of which the adjacent micro-structure columns are fixed.

12. Method according to claim 10 or 11, wherein at least two intermediate chamber materials are arranged in the micro-column intermediate chamber between the adjacent micro-columns, which respectively form at least one coherent intermediate chamber layer.

13. Method according to one of claims 1 to 12, having the following further method step:
the formation of a micro-column cavity (29) in at least one of the micro-columns.

14. Method according to one of claims 1 to 13, having the following further method step:
the formation of a micro-column diameter varying along the micro-column longitudinal extension of the micro-column on at least one of the micro-columns.

## Revendications

1. Procédé de production d'une microstructure tridimensionnelle, qui présente une multiplicité de micro-colonnes (2) disposées l'une à côté de l'autre, essentiellement parallèles l'une à l'autre en ce qui concerne leur extension longitudinale de micro-colonne respective (21) et espacées l'une de l'autre avec au moins un matériau de micro-colonne non monocristallin (20, 201, 202), qui présentent respectivement un diamètre de micro-colonne (22) compris dans la plage de 0,1 µm à 200 µm, et un intervalle de micro-colonnes (3) disposé entre des micro-colonnes voisines avec une distance des micro-colonnes (31) entre les micro-colonnes voisines choisie dans la plage de 1 µm à 100 µm, dans lequel au moins une des micro-colonnes présente au moins deux sections (210, 220) disposées le long de l'extension longitudinale de micro-colonne avec des matériaux de micro-colonne non monocristallins différents l'un de l'autre (201, 202), avec les étapes de procédé suivantes:
a) préparation d'un gabarit (5) avec un matériau de gabarit (50), dans lequel le gabarit présente une structure de gabarit tridimensionnelle (51), essentiellement inverse de la microstructure, avec des cavités de gabarit de type colonne (52),
b) agencement d'un premier matériau de micro-colonne et d'un deuxième matériau de micro-colonne différent du premier matériau de micro-colonne dans les cavités de type colonne, de telle manière que les micro-colonnes apparaissent, et qu'au moins une des micro-colonnes présente au moins deux sections (210, 220) disposées le long de l'extension longitudinale de micro-colonnes avec
des matériaux de micro-colonne non monocristallins (201, 202) différents l'un de l'autre, et
c) enlèvement au moins partiel du matériau de gabarit.

2. Procédé selon la revendication 1, dans lequel, pour l'agencement du matériau de micro-colonne, on exécute les étapes de procédé suivantes:
d) introduction de matière première du matériau de micro-colonne dans les cavités et
e) transformation de la matière première du matériau de micro-colonne en matériau de microstructure.

3. Procédé selon la revendication 1 ou 2, dans lequel on utilise un gabarit avec du silicium comme matériau de gabarit.

4. Procédé selon l'une quelconque des revendications 1 à 3, dans lequel on utilise un gabarit avec un support avec un matériau de support pour la microstructure.

5. Procédé selon l'une quelconque des revendications 1 à 4, dans lequel, après l'enlèvement du matériau de gabarit, on dispose une couche fonctionnelle (28) avec un matériau fonctionnel (280) sur les extrémités (26) d'au moins une partie des micro-colonnes.

6. Procédé selon l'une quelconque des revendications 1 à 5, dans lequel le diamètre de micro-colonne est choisi dans la plage de 0,3 µm à 200 µm.

7. Procédé selon l'une quelconque des revendications 1 à 6, dans lequel l'extension longitudinale de micro-colonne d'au moins une des micro-colonnes est choisie dans la plage de 50 µm à 10 mm et en particulier dans la plage de 100 µm à 1 mm.

8. Procédé selon l'une quelconque des revendications 1 à 7, dans lequel au moins deux des micro-colonnes présentent des matériaux de micro-colonne (201, 202) non cristallins différents l'un de l'autre.

9. Procédé selon l'une quelconque des revendications 1 à 8, présentant en outre l'étape de procédé suivante:
- pose d'au moins une gaine (27) avec au moins un matériau de gaine sur au moins une des micro-colonnes, dans lequel le matériau de micro-colonne de la micro-colonne et le matériau de gaine de la gaine sont différents l'un de l'autre.

10. Procédé selon l'une quelconque des revendications 1 à 9, présentant en outre l'étape de procédé suivante:
- agencement d'au moins un matériau d'intervalle (33) dans l'intervalle de micro-colonnes entre les micro-colonnes voisines.

11. Procédé selon la revendication 10, dans lequel le matériau d'intervalle forme une couche d'intervalle continue (32), par laquelle les colonnes de microstructure voisines sont fixées.

12. Procédé selon la revendication 10 ou 11, dans lequel au moins deux matériaux d'intervalle, qui forment à chaque fois au moins une couche d'intervalle continue, sont agencés dans l'intervalle de micro-colonnes entre les micro-colonnes voisines.

13. Procédé selon l'une quelconque des revendications 1 à 12, comprenant en outre l'étape de procédé suivante:
- formation d'une cavité de micro-colonne (29) dans au moins une des micro-colonnes.

14. Procédé selon l'une quelconque des revendications 1 à 13, présentant en outre l'étape de procédé suivante:
- formation d'un diamètre de micro-colonne variant le long de l'extension longitudinale de micro-colonne de la micro-colonne sur au moins une des micro-colonnes.
